# EUROPEAN PATENT APPLICATION

(11) **EP 1 487 008 A2**
(43) Date of publication of application: **15.12.2004**
(21) Application number: 04013647.5
(22) Date of filing: 09.06.2004
(51) Int. Cl.: H01L 21/208

(54) **Method for forming a Si film, si film and solar battery**

(30) Priority: 12.06.2003 JP 2003167493
(71) Applicant: Tohoku University, Sendai City, Miyagi Prefecture (JP)
(72) Inventor: Nakajima, Kazuo, Kurokawa-gun Miyagi Pref. (JP); Usami, Noritaka, Sendai City Miyagi Pref. (JP); Ujihara, Toru, Tagajyo City Miyagi Pref. (JP); Fujiwara, Kozo, Sendai City Miyagi Pref. (JP)
(74) Representative: Wibbelmann, Jobst, Dr., Dipl.-Chem.

(57) **Abstract**

A Si melt is contacted to a main surface of a Si substrate made of metallurgical Si raw material to conduct liquid phase epitaxy within a temperature range around Si melting point and to form a Si crystal thin film on the main surface of the Si substrate.

## Description

### BACKGROUND OF THE INVENTION

### Field of the Invention

This invention relates to a method for forming a Si film, the same Si film, and a solar battery which is made of the same Si film by means of the same forming method.

### Description of the related art

In order to diffuse safest and environmental Si solar batteries on a large scale and on a global scale, it is required to develop in low cost and in high productivity safest manufacturing technology of solar battery utilizing global rich sources. As of now, in both domestically and abroad, such as manufacturing technology as to complete a solar battery as a device from a Si melt has been mainly developed by means of casting.

Since the casting method, however, utilizes a solidifying method of melt where the temperature gradient of the solid-liquid interface is increased, it is inherently difficult to develop the crystal quality of the obtained Si polycrystal. Moreover, since pure Si raw materials are expensive, the quality of Si raw materials to be employed is restricted. In this point of view, such a thin film growing method as to form a Si film on an inorganic substrate by means of vapor phase epitaxy has been also developed, in addition to the above-mentioned manufacturing technology.

With the thin film growing method, however, since epitaxial growing technique utilizing a crystal substrate is not employed, but driving force of growth obtained on the large shift from the equilibrium condition is employed, it is difficult to develop the crystal quality of the obtained thin film. With the thin film growing method, in addition, since a substrate made of glass is employed, the growing temperature can not be enhanced, so that only micro grains are formed in the thin film, and large grains can not be formed. Therefore, the efficiency of a solar battery made of the thin film can not be enhanced.

In this point of view, as of now, it is eagerly desired to develop a forming technique of Si crystal thin film of low defect density and thus, high quality wherein expensive Si raw materials are not employed and whereby the high efficiency of a solar battery can be realized.

### SUMMERY OF THE INVENTION

It is an object of the present invention to provide a forming technique of Si crystal thin film of low defect density and thus, high quality wherein expensive Si raw materials are not employed and whereby the high efficiency of a solar battery can be realized.

For achieving the above object, this invention relates to a method for forming a Si thin film, comprising the steps of:
preparing a Si melt kept at a temperature near Si melting point,
preparing a Si substrate made of Si single crystal or Si polycrystal, and
contacting the Si melt to a main surface of the Si substrate to conduct liquid phase epitaxy within a temperature range around the Si melting point and to form a Si crystal thin film on the main surface of the Si substrate.

The inventors had been intensely studied to achieve the above object, and then, paid an attention to liquid phase epitaxial (LPE) technique because a crystal thin film of high quality can be easily formed by the LPE technique under near equilibrium growth condition. At first, the inventors dissolve Si raw materials in a solvent made of a melt of low melting point metal to form a metallic solution with Si therein ,and conduct the LPE technique utilizing the metallic solution. In this case, however, since the LPE technique is conducted under lower temperature condition than the melting point of Si, the intended high crystal quality and flattened Si crystal thin film can not be formed because of the large contamination of metallic elements from the metallic solution and the low growing temperature.

In this point of view, the inventors made an attempt to conduct the LPE technique under the condition almost close to the solid-liquid equilibrium by utilizing the Si melt directly, to form a low defect density-high quality and flattened Si crystal thin film. With the LPE technique utilizing the Si melt, even though a relatively low crystal quality Si substrate is employed, the crystal quality of the obtained Si thin film is not almost degraded. Therefore, the Si substrate can be made of a low cost metallurgical Si raw material, and thus, the manufacturing cost of the Si crystal thin film can be reduced largely.

As a result, according to the forming method of the present invention as mentioned above, the low defect density and thus, high quality Si crystal thin film can be formed in low cost. In the fabrication of a solar battery, therefore, if the forming method of Si crystal thin film according to the present invention is employed, the conversion efficiency of the solar battery can be enhanced sufficiently and the manufacturing cost of the solar battery can be reduced.

Herein, the wording "metallurgical Si raw material" means not expensive Si raw material which is not refined sufficiently and exist in abundance on the globe.

In a preferred embodiment of the present invention, the LPE is conducted within a temperature range of ±5°C of Si melting point. The inherent melting point of Si is 1414°C, but fluctuated due to thermal fluctuation, so that the real melting point is shifted from the inherent melting point. In this case, since the above-mentioned temperature range is a supercooling temperature region of Si melt, the Si melt can be maintained in liquid phase not through solidification. Therefore, the LPE can be conducted in good condition.

In another preferred embodiment of the present invention, the LPE is conducted under the condition that the Si melt is maintained within a temperature range between the Si melting point and +5°C of the Si melting point, and a portion of the Si substrate is contacted to the Si melt to be melted, and the temperature of the region of the Si melt in the vicinity of the Si substrate is maintained lower than the Si melting point. In this case, the LPE can be conducted under the condition closer to solid-liquid equilibrium, and thus, the low defect density-high quality and flattened Si crystal thin film can be obtained.

In still another preferred embodiment, at least small amount of one element selected from the group consisting of In, Ga, Sn, Al, Au-Bi and Cu is added into the Si melt. In this case, the melting point (solidifying point) of the Si melt can be slightly reduced, and the melting point zone can be enlarged. Therefore, in the LPE, the temperature control of the Si melt can be simplified, and the LPE can be conducted surely.

In the latter preferred embodiment, the amount of element to be added can be set within 0.01-10 at%.

### BRIEF DESCRIPTION OF THE DRAWINGS

For better understanding of the present invention, reference is made to the attached drawings, wherein
Fig. 1 is an explanatory view illustrating one embodiment of the Si crystal thin film forming method of the present invention,
Fig. 2 is also an explanatory view illustrating the embodiment of the Si crystal thin film forming method of the present invention,
Fig. 3 is also an explanatory view illustrating the embodiment of the Si crystal thin film forming method of the present invention,
Fig. 4 is an explanatory view illustrating another embodiment of the Si crystal thin film forming method of the present invention,
Fig. 5 is also an explanatory view illustrating the another embodiment of the Si crystal thin film forming method of the present invention,
Fig. 6 is also an explanatory view illustrating the another embodiment of the Si crystal thin film forming method of the present invention, and
Fig. 7 is an explanatory view illustrating still another embodiment of the Si crystal thin film forming method of the present invention.

### DESCRIPTION OF THE PREFERRED EMBODIMENTS

This invention will be described in detail hereinafter.

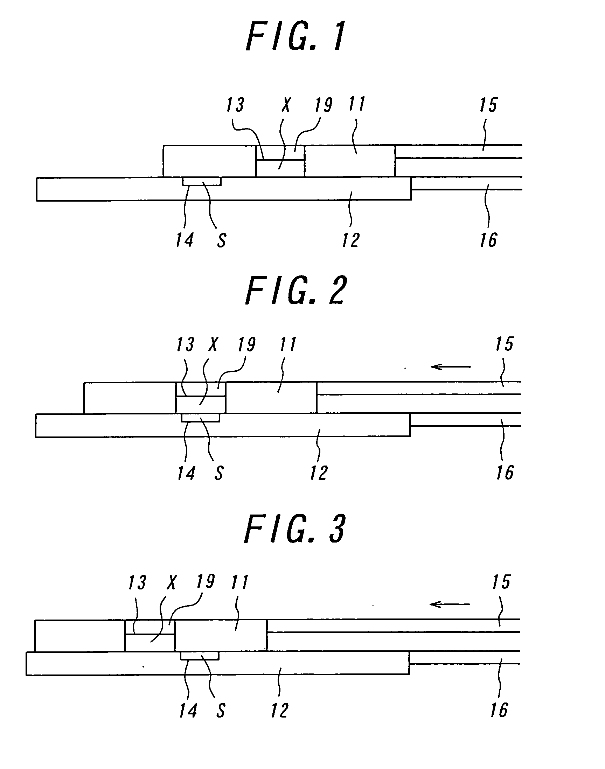

Figs. 1-3 relate to one embodiment of the Si crystal thin film forming method of the present invention wherein a parallel sliding board is employed. As illustrated in Fig. 1, a first member 11 with a depressed Si melt holder 13 and a second member 12 with a depressed Si substrate holder 14 are prepared so that the Si melt holder 13 is opposed to the Si substrate holder 14. The Si melt holder 13 is capped with the carbon or quartz cap 19. The first member 11 and the second member 12 are disposed, for example, in a lateral type furnace (not shown). A rotatable sliding board may be employed, instead of the parallel sliding board.

The first member 11 and the second member 12 are connected to driving shafts 15 and 16, respectively. The driving shafts 15 and 16 are connected to a motor (not shown) so that the first member 11 and the second member 12 are moved laterally (in horizontal direction). The driving shafts 15 and 16 may be driven by man power, instead of the motor. A Si melt X is charged and supported in the Si melt holder 13, and a Si substrate S is supported in the Si substrate holder 14.

The Si substrate S can be made of any kind of Si raw material, and in the present invention, can be made of meta radical Si raw material which exist in abundance on the globe. Since the metallurgical Si raw material is not expensive, the intended Si crystal thin film can be formed in low cost.

Under the state illustrated in Fig. 1, the Si melt X is heated to a given temperature within a temperature range of 1°C ~ 100°C above the Si melting point. The LPE can be conducted in good condition at a first temperature wherein the Si melt is not solidified. Concretely, the first temperature is set within a temperature range of -5°C ~ +5°C (±5°C) of Si melting point.

Then, the motor (not shown) is driven, and the first member 11 is slid in the left direction with the driving shaft 15 so that as illustrated in Fig. 2, the Si melt holder 13 is opposed to the Si substrate holder 14. Then, the Si substrate S is contacted to the Si melt X so that an intended Si crystal thin film is epitaxially grown on the Si substrate S.

Then, after the Si melt X approaches to a second temperature, the first member 11 is slid in the left direction as illustrated in Fig. 3 so that the Si melt X is left away from the Si substrate S to terminate the LPE. The second temperature is not restricted, but in view of the continuous epitaxial growth, preferably set to the same temperature as the first temperature or lower temperature than the first temperature so that the Si melt S is not solidified. Concretely, the second temperature is preferably set within a temperature range between -10°C ~ +5°C of the Si melting point.

Through the above-mentioned steps, the intended Si crystal thin film can be formed on the Si substrate by means of LPE. The thickness of the Si crystal thin film can be varied by controlling the contacting period of time between the Si melt X and the Si substrate S and the temperature of the Si melt X.

At least one element selected from the group consisting of In, Ga, Sn, Al, Au-Bi and Cu can be added into the Si melt. The amount of element to be added can be set within 0.01-10 at%. In this case, the melting point (solidifying point) of the Si melt can be reduced, and the melting point zone can be enlarged. Therefore, in the LPE, the temperature control of the Si melt can be simplified, and the LPE can be conducted surely.

When such an additive element as mentioned above is added into the Si melt X, the additive element is contained in the Si crystal thin film. If the amount of the additive element to be added is set within the above-mentioned range, in Ga additive element with small distribution coefficient, the additive element content in the Si crystal thin film is set within 1×10⁻⁹ -1×10⁻² at%.

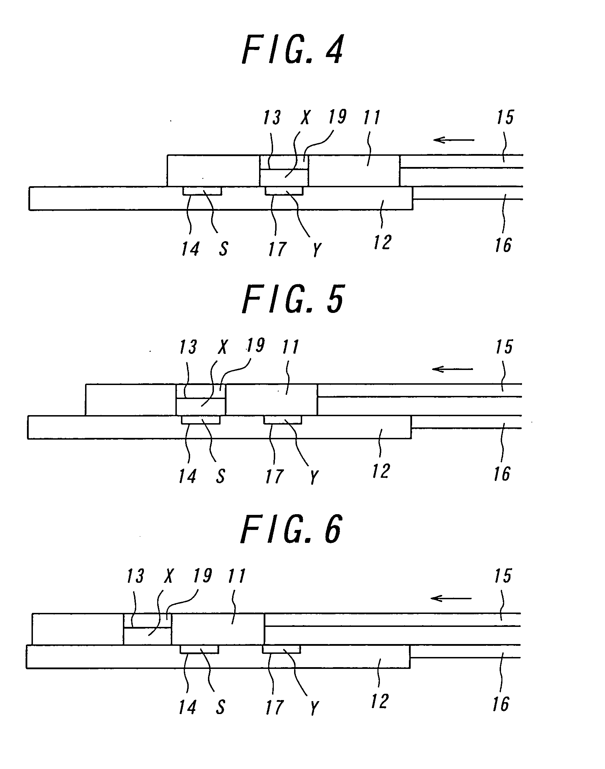

Figs. 4-6 relate to another embodiment of the Si crystal thin film forming method of the present invention. In this embodiment, too, an intended Si crystal thin film is formed by utilizing the sliding board. In this embodiment, like or corresponding members to the ones in the embodiment relating to Figs. 4-6 are employed, but the second member 12 includes an additive element melt holder 17 in addition to the substrate holder 14. Into the additive element holder 17 is charged and supported a melt of at least one element selected from the group consisting of In, Ga, Sn, Al, Au-Bi and Cu or Si crystal with a proper amount of at least one element selected from the group consisting of In, Ga, Sn, Al, Au-Bi and Cu.

First of all, as illustrated in Fig. 4, the first member 11 and the second member 12 are prepared so that the Si melt holder 13 is opposed to the additive element melt holder 17. In this case, the Si melt X is contacted to the additive element melt or the Si crystal with the additive element Y so that additive elements in the additive element melt or the Si crystal Y are contained in the Si melt X through convection and diffusion. The Si melt holder 13 is capped with the carbon or quartz cap 19.

Then, the Si melt X is heated to a given temperature above the Si melting point. Since the Si melt X contains the additive elements, in order to conduct the LPE in good condition, the first temperature at which the crystal growth starts is set within a temperature range between the Si melting point and-50°C of the Si melting point.

Then, the motor (not shown) is driven, and the first member 11 is slid in the left direction with the driving shaft 15 so that as illustrated in Fig. 5, the Si melt holder 13 is opposed to the Si substrate holder 14. Then, the Si substrate S is contacted to the Si melt X so that the intended Si crystal thin film is epitaxially grown on the Si substrate S.

Then, after the Si melt X approaches to a second temperature, the first member 11 is slid in the left direction as illustrated in Fig. 6 so that the Si melt X is left away from the Si substrate S to terminate the LPE. The second temperature is preferably set within a temperature range between the Si melting point and -60°C of the Si melting point.

Through the above-mentioned steps, the intended Si crystal thin film can be formed on the Si substrate by means of LPE. The thickness of the Si crystal thin film can be also varied by controlling the contacting period of time between the Si melt X and the Si substrate S and the temperature of the Si melt X. In this embodiment, if Ga additive element is employed, the Si crystal thin film contains the Ga additive element by 1 × 10⁻⁹ -1 × 10⁻² at%.

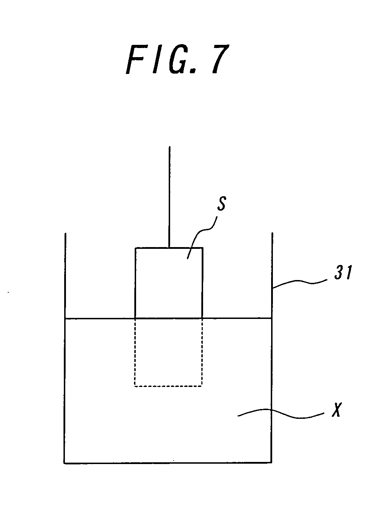

Fig. 7 relates to still another embodiment of the Si crystal thin film of the present invention. In Fig. 7, the Si melt X is charged into a given container 31, and the Si substrate is immersed into the Si melt X. In this case, the intended Si crystal thin film can be formed on the Si substrate through epitaxial growth.

The thickness of the Si crystal thin film can be varied by controlling the temperature and the immersing period of time of the Si melt X. Moreover, at least one element selected from the group consisting of In, Ga, Sn, Al, Au-Bi and Cu can be added into the Si melt. In this case, too, the melting point (solidifying point) of the Si melt can be reduced, and the melting point zone can be enlarged. Therefore, in the LPE, the temperature control of the Si melt can be simplified, and the LPE can be conducted surely.

### Example:

In this Example, an intended Si crystal thin film was formed according to the steps illustrated in Figs. 1-3. First of all, pure Si raw material was prepared and heated to 1450°C to form the Si melt X. Then, the Si substrate S was made of metallurgical Si raw material. The Si melt X was kept at 1415°C, and as illustrated in Fig. 2, the Si substrate S was contacted to the Si melt X for about 0.5 ~ 1 minutes during cooling the Si melt at 1°C/min. to form the intended Si crystal thin film on the Si substrate S through LPE. Then, as illustrated in Fig. 3, the Si substrate S was left away from the Si melt X to terminate the LPE.

The thickness of the Si crystal thin film was 50 µm, and the lifetime was 5 µs. Then, a solar battery was made of the Si crystal thin film, and it was turned out that the conversion efficiency of the solar battery was about 8% on the process of Bell Communications Research.

Although the present invention was described in detail with reference to the above examples, this invention is not limited to the above disclosure and every kind of variation and modification may be made without departing from the scope of the present invention. For example, if a Ge melt is mixed to the Si melt, the SiGe crystal thin film can be formed, instead of the Si crystal thin film.

As mentioned above, according to the present invention can be provided a forming technique of Si crystal thin film of low defect density and thus, high quality wherein expensive Si raw materials are not employed and whereby the high efficiency of a solar battery can be realized.,

## Claims

1. A method for forming a Si thin film, comprising the steps of:
preparing a Si melt kept at a temperature near Si melting point,
preparing a Si substrate made of Si single crystal or Si polycrystal, and
contacting said Si melt to a main surface of said Si substrate to conduct liquid phase epitaxy within a temperature range around said Si melting point and to form a Si crystal thin film on said main surface of said Si substrate.

2. The forming method as defined in claim 1, wherein said Si substrate is made of metallurgical Si raw material.

3. The forming method as defined in claim 1 or 2, wherein said liquid phase epitaxy is conducted within a temperature range of ±5°C of said Si melting point.

4. The forming method as defined in any one of claims 1-3, wherein said liquid phase epitaxy is conducted under the condition that said Si melt is maintained within a temperature range between said Si melting point and +5°C of said Si melting point, and a portion of said Si substrate is contacted to said Si melt, to be melted, and a temperature of a region of said Si melt in the vicinity of said Si substrate is maintained lower than said Si melting point.

5. The forming method as defined in any one of claims 1-4, wherein said liquid phase epitaxy includes the steps of:
supporting said Si melt in a melt holder formed at a sliding type first member,
supporting said Si substrate in a substrate holder formed at a sliding type second member,
sliding at least one of said first member and said second member when a temperature of said Si melt approaches to a first temperature around said Si melting point, to contact said Si melt to said main surface of said Si substrate and to initiate growth of said Si crystal thin film on said main surface of said Si substrate through epitaxial growth, and
sliding at least one of said first member and said second member when said temperature of said Si melt approaches to a second temperature lower than the first temperature, to leave away said Si melt from said main surface of said Si substrate to terminate said epitaxial growth.

6. The forming method as defined in claim 5, wherein said first temperature is set within a temperature range of ±5°C of said Si melting point.

7. The forming method as defined in claim 5 or 6, wherein said second temperature is set within a temperature range between -10°C ~ +5°C of said Si melting point.

8. The forming method as defined in any one of claims 1-7, further comprising the step of adding into said Si melt at least one element selected from the group consisting of In, Ga, Sn, Al, Au-Bi and Cu.

9. The forming method as defined in claim 8, wherein a content of said element is set within 0.01-10 at%.

10. The forming method as defined in claim 8 or 9, wherein said liquid phase epitaxy includes the steps of:
supporting said Si melt in a melt holder formed at a sliding type first member,
supporting said Si substrate in a substrate holder formed at a sliding type second member,
supporting a melt made of said element to be added into said Si melt in an additive element melt holder formed at said second member,
sliding at least one of said first member and said second member to contact said Si melt to said additive element melt and to add said element into said Si melt,
sliding at least one of said first member and said second member when a temperature of said Si melt approaches to a first temperature around said the first temperature, to contact said Si melt to said main surface of said Si substrate and to initiate growth of said Si crystal thin film on said main surface of said Si substrate through epitaxial growth, and
sliding at least one of said first member and said second member when said temperature of said Si melt approaches to a second temperature lower than said Si melting point, to leave away said Si melt from said main surface of said Si substrate to terminate said epitaxial growth.

11. The forming method as defined in claim 10, wherein said first temperature is set within a temperature range between said Si melting point and -50°C of said Si melting point.

12. The forming method as defined in claim 10 or 11, wherein said second temperature is set within a temperature range between said Si melting point and -60°C of said Si melting point.

13. The forming method as defined in any one of claims 1-4 and 8-9, wherein said liquid phase epitaxy includes the steps of:
charging said Si melt in a container, and
immersing said Si substrate in said Si melt for a given period of time to form said Si crystal thin film on said main surface of said Si substrate through epitaxial growth.

14. A Si crystal thin film formed by a forming method as defined in any one of claims 1-13.

15. A Si crystal thin film formed on a substrate made of metallurgical Si raw material.

16. The Si crystal thin film as defined in claim 15, comprising at least one element selected from the group consisting of In, Ga, Sn, Al, Au-Bi and Cu.

17. The Si crystal thin film as defined in claim 16, wherein a content of said element is set within 1×10⁻⁹ -1×10⁻² at%.

18. A solar battery comprising a Si crystal thin film as defined in any one of claims 14-17.
